# EUROPEAN PATENT APPLICATION

(11) **EP 4 624 961 A1**
(43) Date of publication of application: **01.10.2025**
(21) Application number: 24215142.1
(22) Date of filing: 25.11.2024
(51) Int. Cl.: G01R 31/392, H02J 7/00, H01M 10/48, B60L 58/16

(54) **METHOD AND SYSTEM FOR BATTERY MANAGEMENT**

(30) Priority: 26.03.2024 KR 20240041435
(71) Applicant: SAMSUNG SDI CO., LTD., Yongin-si, Gyeonggi-do 17084 (KR)
(72) Inventor: Park, Joonho, 17084 Yongin-Si, Gyeonggi-do (KR); Jeong, Areum, 17084 Yongin-si, Gyeonggi-do (KR); Oh, Seiyoung, 17084 Yongin-Si Gyeonggi-do (KR); Ahn, Gijang, 17084 Yongin-si, Gyeonggi-do (KR)
(74) Representative: Gulde & Partner

(57) **Abstract**

The present disclosure relates to a battery management method and relates to providing a battery management method with improved safety and user convenience. To this end, the battery management method of the present disclosure may include monitoring a lower-level battery and receiving monitoring data, estimating a damage possibility of an upper-level battery including the lower-level battery based on the received monitoring data, and changing a charge/discharge range of the upper-level battery from a first charge/discharge range to a second charge/discharge range based on the estimated damage possibility.

## Description

### FIELD

Aspects of some embodiments of the present disclosure relate to a method and system for battery management.

### BACKGROUND

Generally, secondary batteries are rechargeable batteries and refer to batteries that can be charged and discharged multiple times. These secondary batteries may be mainly used in various applications such as electronic products (smartphones, laptops, tablets, etc.), electric vehicles, solar power generation, and emergency power supplies. For example, lithium-ion batteries have high energy density and high charge and discharge efficiency and thus are used in various electronic products and electric vehicles.

These secondary batteries may gradually deteriorate in performance as they are repeatedly charged and discharged and may be damaged after a number of charge and discharge cycles. If a secondary battery is damaged, there may be problems for the safety of the user of the secondary battery. For example, if a secondary battery gets damaged while a car is being driven, it could lead to a fire and a vehicle accident.

The above information disclosed in this Background section is for enhancement of understanding of the background of the present disclosure, and therefore, it may contain information that does not constitute related (or prior) art.

### SUMMARY

An object to be achieved by the present disclosure is to provide a method and system for battery management to solve the problems mentioned herein.

These and other aspects and features of the present disclosure will be described in or will be apparent from the following description of embodiments of the present disclosure.

According to some embodiments of the present disclosure to achieve the objects mentioned above, a battery management method includes monitoring a lower-level battery and receiving monitoring data, estimating a damage possibility of an upper-level battery including the lower-level battery based on the received monitoring data, and changing a charge/discharge range of the upper-level battery from a first charge/discharge range to a second charge/discharge range based on the estimated damage possibility.

According to some embodiments of the present disclosure, the changing to the second charge/discharge range may include selecting the second charge/discharge range, which is one of a plurality of predetermined charge/discharge range candidates, based on at least one of a depth of discharge (DOD) of the first charge/discharge range, a state of health (SOH) of the upper-level battery, target mechanical characteristics, or target electrical characteristics.

According to some embodiments of the present disclosure, the first charge/discharge range and the plurality of predetermined charge/discharge range candidates may all have the same depth of discharge.

According to some embodiments of the present disclosure, the (target) mechanical characteristics may include a swelling characteristic and a damage characteristic.

According to some embodiments of the present disclosure, the (target) electrical characteristics may include an internal resistance characteristic and a power characteristic.

According to some embodiments of the present disclosure, the changing to the second charge/discharge range may include changing the charge/discharge range of the upper-level battery from the first charge/discharge range to the second charge/discharge range in response to determining that the estimated damage possibility is greater than or equal to a predetermined threshold, and the upper-level battery may have a lower damage possibility in the second charge/discharge range than in the first charge/discharge range.

According to some embodiments of the present disclosure, the changing to the second charge/discharge range may include changing the charge/discharge range of the upper-level battery from the first charge/discharge range to the second charge/discharge range in response to determining that the estimated damage possibility is less than a predetermined threshold, and the upper-level battery may have superior electrical characteristics in the second charge/discharge range than in the first charge/discharge range.

According to some embodiments of the present disclosure, the changing to the second charge/discharge range may include determining that the estimated damage possibility is less than a predetermined threshold, receiving a driving pattern of a user, and selecting the second charge/discharge range having electrical characteristics associated with the driving pattern of the user out of a plurality of predetermined charge/discharge range candidates.

According to some embodiments of the present disclosure, depths of discharge of the first charge/discharge range and the second charge/discharge range may be the same, and start points and end points of the first charge/discharge range and the second charge/discharge range may be different.

According to some embodiments of the present disclosure, a usage capacity of the upper-level battery according to the first charge/discharge range and a usage capacity of the upper-level battery according to the second charge/discharge range may be the same.

According to some embodiments of the present disclosure, estimating the damage possibility of the upper-level battery may include determining mechanical characteristics and electrical characteristics of the lower-level battery based on the monitoring data, estimating at least one of mechanical characteristics or electrical characteristics of the upper-level battery based on the mechanical characteristics and electrical characteristics of the lower-level battery, and estimating the damage possibility of the upper-level battery based on at least one of the estimated mechanical characteristics or electrical characteristics of the upper-level battery.

According to some embodiments of the present disclosure, the monitoring data may include at least one of position sensor data, pressure sensor data, state of charge (SOC) data, or power data associated with the lower-level battery.

According to some embodiments of the present disclosure, determining the mechanical characteristics and electrical characteristics of the lower-level battery may include determining swelling data of the lower-level battery based on at least one of the position sensor data or the pressure sensor data associated with the lower-level battery, and determining a damage characteristic of the lower-level battery based on at least one of the swelling data, the state of charge data, or the power data of the lower-level battery.

According to some embodiments of the present disclosure, the mechanical characteristics and electrical characteristics of the upper-level battery may be estimated using a predefined correlation model between the lower-level battery and the upper-level battery.

According to some embodiments of the present disclosure, the monitoring data may include at least one of position sensor data, pressure sensor data, state of charge (SOC) data, or power data associated with the lower-level battery, and estimating the damage possibility of the upper-level battery may include determining swelling data of the lower-level battery based on at least one of the position sensor data or the pressure sensor data associated with the lower-level battery, determining a damage characteristic of the lower-level battery based on at least one of the swelling data, the state of charge data, or the power data of the lower-level battery, and estimating a damage characteristic of the upper-level battery based on the damage characteristic of the lower-level battery.

According to some embodiments of the present disclosure, estimating the damage possibility of the upper-level battery may include estimating the damage possibility of the upper-level battery based on the monitoring data and a predictive model, and the predictive model may be trained based on training data including first characteristic data associated with the lower-level battery and second characteristic data associated with the upper-level battery.

According to some embodiments of the present disclosure, the plurality of predetermined charge/discharge range candidates may be stored in lookup tables, and the lookup tables may include mechanical characteristics and electrical characteristics for each charge/discharge range candidate of the plurality of predetermined charge/discharge range candidates.

According to some embodiments of the present disclosure, the upper-level battery may include a plurality of lower-level batteries including the lower-level battery, and the monitoring data may be obtained from some of the plurality of lower-level batteries.

According to some embodiments of the present disclosure to achieve the above-mentioned objects, a computer program is stored on a computer-readable recording medium for executing the battery management method according to some embodiments on a computer.

According to some embodiments of the present disclosure to achieve the above-mentioned objects, a battery management system includes a memory and at least one processor connected to the memory and configured to execute at least one computer-readable program included in the memory, wherein the at least one computer-readable program includes instructions for monitoring a lower-level battery and receiving monitoring data, estimating a damage possibility of an upper-level battery including the lower-level battery based on the received monitoring data, and changing a charge/discharge range of the upper-level battery from a first charge/discharge range to a second charge/discharge range based on the estimated damage possibility.

According to some embodiments of the present disclosure, if it is determined that the damage possibility of the upper-level battery is greater than or equal to a predetermined threshold, the charge/discharge range of the upper-level battery can be changed to a charge/discharge range having a lower damage possibility. As a result, the safety of the upper-level battery can be improved.

According to some embodiments of the present disclosure, if it is determined that the damage possibility of the upper-level battery is less than or equal to the predetermined threshold, the charge/discharge range of the upper-level battery can be changed to a charge/discharge range having electrical characteristics associated with the driving pattern of the user. As a result, the driving characteristics of the vehicle can be improved.

According to some embodiments of the present disclosure, by using a trained artificial neural network model, the time and cost required to obtain the mechanical and/or electrical characteristic data of the lower-level battery/upper-level battery can be reduced.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 is a diagram for describing a battery management system in accordance with some embodiments of the present disclosure;
FIG. 2 is a diagram for describing a processor in accordance with some embodiments of the present disclosure;
FIG. 3 is a flowchart for describing an example of a method for generating a correlation model between a lower-level battery and an upper-level battery in accordance with some embodiments of the present disclosure;
FIG. 4 is a table for describing a method of estimating a damage possibility in accordance with some embodiments of the present disclosure;
FIG. 5 is a flowchart for describing a method of tabulating characteristics of an upper-level battery in accordance with some embodiments of the present disclosure;
FIG. 6 is a diagram for describing lookup tables in accordance with some embodiments of the present disclosure;
FIG. 7 is a flowchart for describing a battery management method in accordance with some embodiments of the present disclosure;
FIG. 8 is a diagram for describing a charge/discharge range and a practical use range of a battery in accordance with some embodiments of the present disclosure;
FIG. 9 is a diagram for describing a method of changing a charge/discharge range based on electrical characteristics in accordance with some embodiments of the present disclosure;
FIG. 10 is a diagram for describing a battery management method in accordance with some embodiments of the present disclosure;
FIG. 11 is a diagram for describing a vehicle in accordance with some embodiments of the present disclosure;
FIG. 12 is a diagram for describing an example in which a vehicle and a vehicle control part communicate with each other in accordance with some embodiments of the present disclosure;
FIG. 13 is a diagram showing an example of controlling a charge/discharge range based on driver proclivity data and a possibility of battery damage in accordance with some embodiments of the present disclosure; and
FIG. 14 is a diagram showing an example of controlling a charge/discharge range based on a possibility of battery damage in accordance with some embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In the present disclosure, a "battery" may refer to a unit battery or a bundle of unit batteries, such as a battery cell, a battery module, or a battery pack.

In the present disclosure, a "charge/discharge range" may refer to the limits set for charging and discharging to ensure the safe and efficient use of a battery. The charge range indicates the maximum upper limit of the battery's capacity that can be charged, while the discharge range indicates the minimum lower limit of the battery's capacity that can be discharged. Instead of utilizing the full battery's capacity, safety margins are included to prevent overcharging and over-discharging. The charge/discharge range help prevent damage to the battery, ensuring long-term performance and stable operation. The charge/discharge range may vary depending on the state of the battery.

In the present disclosure, a "swelling characteristic" may refer to a characteristic of the swelling value of a battery. The swelling value may be small if the swelling characteristic is excellent, and the swelling value may be large if the swelling characteristic is poor. For example, the swelling value may be the difference between the amount of deformation at state of charge (SOC) maximum (Max) and the amount of deformation at SOC minimum (Min). In this case, the swelling value of a battery cell may be the difference between the amount of deformation at the SOC Max and the amount of deformation at the SOC Min of the battery cell.

In the present disclosure, a "damage characteristic" may refer to the damage possibility of an appliance due to fatigue of a battery. For example, the damage possibility may be low in a particular charge/discharge cycle if the damage characteristic is excellent, and the damage possibility may be high in the same charge/discharge cycle if the damage characteristic is poor.

In the present disclosure, "internal resistance" may refer to the internal resistance of a battery. The internal resistance may include the direct current internal resistance (DCIR) and alternating current internal resistance (ACIR) of the battery.

In the present disclosure, a "power characteristic" may refer to the power characteristic of a battery. For example, the battery can supply more electrical energy for a particular period of time if the power characteristic is excellent, but the battery can supply less electrical energy for the same period of time if the power characteristic is poor.

As discussed herein, if a secondary battery is damaged, there may be problems for the safety of the user of the secondary battery. Therefore, it is desirable to make efforts to predict the damage possibility of secondary batteries and to prevent damage to the secondary batteries.

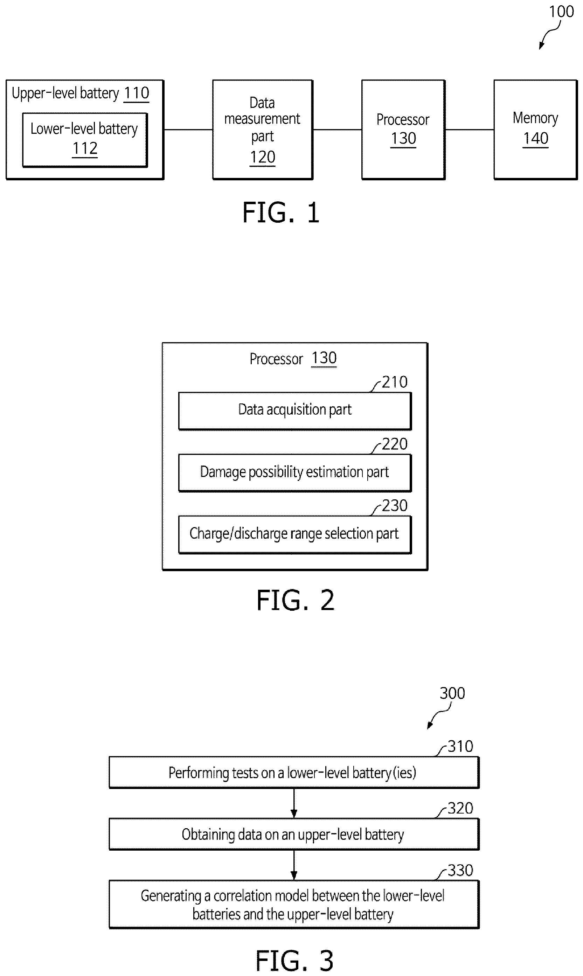

FIG. 1 is a diagram for describing a battery management system in accordance with some embodiments of the present disclosure. Referring to FIG. 1, a battery management system 100 may include an upper-level battery 110, a data measurement part 120, a processor 130, and a memory 140. In one example, the battery management system 100 may be a battery management system of a vehicle.

The upper-level battery 110 may include a lower-level battery 112. The upper-level battery 110 may include a plurality of lower-level batteries 112. In some embodiments, the lower-level batteries 112 may be battery cells or battery modules, and the upper-level battery 110 may be a battery module, battery pack, or battery rack. For example, if the upper-level battery is a battery module, the upper-level battery may include a plurality of battery cells. In another example, if the upper-level battery is a battery pack, the upper-level battery may include a plurality of battery modules and/or a plurality of battery cells.

The battery cell may include a rechargeable secondary battery. For example, the battery cell may include a nickel-cadmium battery, a lead-acid battery, a nickel-metal hydride battery (NiMH), a lithium-ion battery, a lithium polymer battery, etc.

The data measurement part 120 may obtain data by monitoring the lower-level batteries 112. For example, the data measurement part 120 may obtain mechanical and electrical characteristic data of the battery cells by monitoring some of the plurality of battery cells. The data measurement part 120 may monitor the lower-level batteries 112 in real-time, periodically at predetermined intervals, or aperiodically, and may transmit the monitoring data of the lower-level batteries 112 to the processor 130 and/or the memory 140. Here, the mechanical characteristics may include a swelling characteristic, a damage characteristic, etc., and the electrical characteristics may include internal resistance, a power characteristic, etc.

The processor 130 should be construed broadly to encompass general-purpose processors, central processing units (CPUs), microprocessors, digital signal processors (DSPs), controllers, microcontrollers, state machines, etc. In some contexts, the processor 130 may refer to application-specific integrated circuits (ASICs), programmable logic devices (PLDs), field programmable gate arrays (FPGAs), etc. The processor 130 may also refer to a combination of processing devices such as, for example, a combination of a DSP and a microprocessor, a combination of a plurality of microprocessors, a combination of one or more microprocessors in combination with a DSP core, or a combination of any other such components.

The processor 130 may be configured to process instructions of a computer program by performing basic arithmetic, logic, and/or input/output operations. According to some embodiments, the processor 130 may obtain monitoring data of the lower-level batteries 112 monitored by the data measurement part 120. Further, the processor 130 may estimate the damage possibility of the upper-level battery based on the monitoring data. Moreover, the processor 130 may determine whether the damage possibility of the upper-level battery is greater than or equal to a threshold. Furthermore, the processor 130 may change the charge/discharge range of the upper-level battery based on the damage possibility, a lookup table stored in the memory 140, etc.

The memory 140 should be construed broadly to encompass any electronic component capable of storing electronic information. The memory 140 may also refer to various types of processor-readable media, such as random-access memory (RAM), read-only memory (ROM), non-volatile random-access memory (NVRAM), programmable read-only memory (PROM), erasable-programmable read-only memory (EPROM), electrically erasable PROM (EEPROM), flash memory, magnetic or optical data storage, registers, etc. The memory 140 is said to be in electronic communication with the processor 130 if the processor 130 can read information from and/or write information to the memory 140. The memory 140 when integrated into the processor 130 is in electronic communication with the processor 130.

In some embodiments, the memory 140 may include any non-transitory computer-readable recording medium. According to some embodiments, the memory 140 may include a permanent mass storage device. As another example, the permanent mass storage device may be included in the battery management system 100 or may be included in a device that can be accessed by wire or wirelessly by the battery management system 100, as a separate persistent storage device distinct from the memory. As yet another example, the memory 140 may be implemented by being included in the processor 130.

According to some embodiments, the memory 140 may store an operating system and at least one program code (e.g., program code for estimating the damage possibility of the upper-level battery). The memory may store instructions (of at least one computer-readable program) for execution by one or more processors that, when executed by the one or more processors, cause the one or more processors to perform the method according to some techniques described herein. Further, the memory 140 may store a plurality of lookup tables generated from the relationship between the depth of discharge (DOD) and state of health (SOH) of the upper-level battery and the characteristics (e.g., mechanical characteristics and electrical characteristics) of the upper-level battery.

FIG. 2 is a diagram for describing a processor in accordance with some embodiments of the present disclosure. Referring to FIG. 2, the processor 130 may include a data acquisition part 210, a damage possibility estimation part 220, and a charge/discharge range selection part 230. The processor may include at least one processor connected to the memory and configured to execute at least one computer-readable program included in the memory.

The data acquisition part 210 may receive data of the lower-level batteries monitored by the data measurement part. For example, the data acquisition part 210 may receive mechanical and electrical characteristic data of the monitored lower-level batteries from the data measurement part. In other embodiments, the data acquisition part 210 may receive the mechanical and electrical characteristic data of the monitored lower-level batteries from the memory. The data acquisition part 210 may receive the data of the monitored lower-level batteries in real-time, periodically at predetermined intervals, or aperiodically.

The damage possibility estimation part 220 may estimate the damage possibility of the upper-level battery based on the data of the monitored lower-level batteries and a correlation model. Here, the correlation model may be a predefined correlation model between the lower-level batteries and the upper-level battery. The damage possibility estimation part 220 may determine whether the damage possibility is greater than or equal to a predetermined threshold and transmit the determination result to the charge/discharge range selection part 230.

The charge/discharge range selection part 230 may change the charge/discharge range of the upper-level battery based on the determination result and the lookup tables stored in the memory. The upper-level battery may have different mechanical characteristics and electrical characteristics depending on the charge/discharge range even for the same depth of charge/discharge. Therefore, the charge/discharge range selection part 230 may select a charge/discharge range having desired electrical characteristics and/or mechanical characteristics from the lookup tables according to the determination result, and may change the charge/discharge range of the upper-level battery to the selected charge/discharge range.

In some embodiments, the charge/discharge range selection part 230 may change the charge/discharge range of the upper-level battery from a first charge/discharge range to a second charge/discharge range in response to the damage possibility being greater than or equal to the threshold. Here, the upper-level battery may have a lower damage possibility in the second charge/discharge range than in the first charge/discharge range. In other embodiments, the charge/discharge range selection part 230 may change the charge/discharge range of the upper-level battery from the first charge/discharge range to a third charge/discharge range in response to the damage possibility being less than the threshold. Here, the upper-level battery may have superior electrical characteristics in the third charge/discharge range than in the first charge/discharge range. Further, the depths of discharge of the first charge/discharge range, the second charge/discharge range, and the third charge/discharge range may be the same. Moreover, the start points and end points of the first charge/discharge range, the second charge/discharge range, and the third charge/discharge range may be different. Furthermore, the usage capacity of the upper-level battery according to the first charge/discharge range, the usage capacity of the upper-level battery according to the second charge/discharge range, and the usage capacity of the upper-level battery according to the third charge/discharge range may be the same.

In FIG. 2, the respective components of the processor 130 represent functional elements that are functionally distinct from each other, and may be implemented in a form in which a plurality of components is integrated with each other in an actual physical environment. In other embodiments, the respective components of the processor 130 may be implemented separately from each other in an actual physical environment. Further, although shown as a single processor in FIG. 2, the processor 130 may be implemented as a multi-core processor including a plurality of processors (or cores).

FIG. 3 is a flowchart for describing an example of a method for generating a correlation model between a lower-level battery and an upper-level battery in accordance with some embodiments of the present disclosure. At least some steps of method 300 may be performed by at least one processor. Referring to FIG. 3, the method 300 may begin with performing tests on a lower-level battery or batteries (at act 310). For example, mechanical characteristics and electrical characteristics of a lower-level battery(ies) (e.g., a battery cell) may be obtained by performing charge/discharge cycle tests on the lower-level battery(ies). In one example, the charge/discharge cycle tests may be performed from the beginning of life (BOL) to the end of life (EOL) of the lower-level battery(ies). For example, an initial deformation and a swelling swing range of the lower-level battery(ies) may be obtained, and a damage characteristic (e.g., a fatigue damage characteristic) of the lower-level battery(ies) may be derived.

Next, the processor may obtain data on an upper-level battery (at act 320). Here, the upper-level battery may include a plurality of lower-level batteries. The type of the plurality of lower-level batteries included in the upper-level battery may be the same as the type of the lower-level battery on which the tests were performed. For example, the amount of deformation of an appliance according to the state of health (SOH) of the upper-level battery (e.g., a battery module or battery pack) including the plurality of lower-level batteries (e.g., battery cells) on which the tests were performed may be obtained. Here, the SOH is the SOH of the upper-level battery and may be a value determined or estimated using at least one of the voltage, current, internal resistance, or temperature of the upper-level battery. However, there are no limitations on this value, which may be another appropriate value. In another example, mechanical characteristics and electrical characteristics may be obtained for the state of health (SOH) of the upper-level battery including the plurality of lower-level batteries on which the tests were performed.

Next, the processor may generate a correlation model between the lower-level batteries and the upper-level battery (at act 330). For example, the processor may generate a correlation model between the lower-level batteries and the upper-level battery based on the mechanical and electrical characteristics of the lower-level batteries and the mechanical and electrical characteristics of the upper-level battery. In another example, the processor may generate a correlation model based on the amount of appliance deformation of the lower-level batteries and the amount of appliance deformation of the upper-level battery. In this case, the correlation model may be expressed as a damage rate. The processor may derive a damage characteristic of the upper-level battery by using the correlation model.

In some embodiments, at least some steps of the method 300 may utilize three-dimensional (3D) modeling and 3D simulation. For example, via position sensors attached to the node points of the lower-level batteries (e.g., battery cells), the amount of positional change of each node may be 3D modeled and simulated during the charge/discharge tests of the lower-level batteries. Through this, the processor may obtain a movement profile of the lower-level batteries. Based on the movement profile of the lower-level batteries, the processor may train an artificial neural network model that can predict movement/positional changes of each node of the lower-level batteries. For example, convolutional neural network (CNN) supervised learning methods may be used. By utilizing the trained artificial neural network model, the processor may supplement the mechanical characteristic data of the lower-level batteries obtained through tests. For example, by utilizing the trained artificial neural network model, the time and cost required to obtain the mechanical characteristic data of the lower-level batteries can be reduced.

Thereafter, the processor may obtain data on the upper-level battery by using the previously obtained movement profile of the lower-level batteries, the trained artificial neural network model, and/or 3D modeling data of the upper-level battery including the plurality of lower-level batteries. For example, the processor may predict and/or generate data on the amount of positional change (or movement profile) during the charge/discharge of the upper-level battery by using the obtained movement profile of the lower-level batteries within the upper-level battery (e.g., battery module or battery pack) and the 3D modeling data of the upper-level battery.

Next, the processor may generate a correlation model by learning the movement profile tendency of the lower-level batteries and the movement profile tendency of the upper-level battery. Here, the correlation model may be an artificial neural network model.

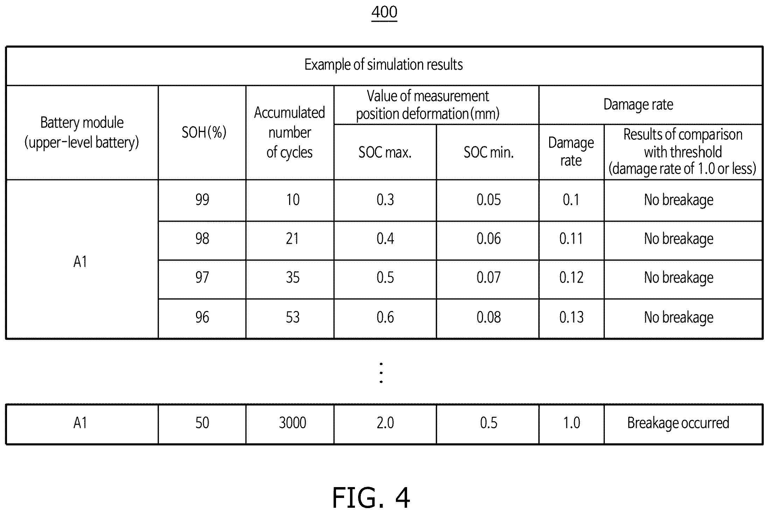

FIG. 4 is a table for describing a method of estimating a damage possibility in accordance with some embodiments of the present disclosure. Referring to FIG. 4, a table 400 shows simulation result values that estimate a damage possibility for a battery module (e.g., upper-level battery A1) including battery cells (e.g., lower-level batteries) by using a damage characteristic of the battery cells.

First, mechanical characteristics of the battery cells may be obtained by performing charge/discharge cycle tests on the battery cells. The charge/discharge cycle tests may be performed for the maximum value of SOC (hereinafter referred to as SOC Max) and the minimum value of SOC (hereinafter referred to as SOC Min) at a particular DOD (e.g., 90%). As a result, initial deformation and swelling values of the battery cells may be obtained, and a fatigue damage characteristic of the battery cells may be derived. For example, it is possible to check after how many cycles a battery cell will break at a particular swelling value, etc. Here, the swelling value (or swing range, swing value) of the battery cells may be the difference between the amount of deformation at SOC Max and the amount of deformation at SOC Min of the battery cells.

Next, the amount of deformation of the battery cells (e.g., lower-level batteries) may be estimated at the battery module (e.g., upper-level battery) level. In charge/discharge cycle tests, the amount of deformation of a battery cell within a battery module and the amount of deformation of a battery cell alone may be different. For example, the amount of deformation of a battery cell within a battery module may be affected by the surrounding components of the battery cell, such as the housing of the battery module. To analyze this effect, 3D modeling data of a battery module including a plurality of battery cells may be used. By using the 3D modeling data of the battery module and the test data of the battery cells, the amount of deformation at the SOC Max and the amount of deformation at the SOC Min of the battery cells within the battery module may be estimated. In other embodiments, by using the 3D modeling data and the test data of the battery cells, the amount of deformation at the SOC Max and the amount of deformation at the SOC Min of the entire battery module may be estimated.

The table 400 shows result values obtained by simulating damage possibilities according to the SOH for the A1 battery module (e.g., upper-level battery). For example, the A1 module has an amount of deformation of 0.6 at SOC Max and an amount of deformation of 0.08 at SOC Min, and is predicted to have a damage rate of 0.13 after accumulation of 53 cycles, at SOH 96%. Because the damage rate reaches a threshold of 1.0 at SOH 50%, it can be estimated that the A1 battery module (e.g., upper-level battery) will break at SOH 50%.

In some embodiments, the processor may perform the simulations described above. The processor may estimate a swelling value at the battery module level and/or a swelling value of a single battery cell within the battery module by using the 3D modeling data of the battery module. Through this process, the processor may estimate the damage possibility of the battery module based on the fatigue damage characteristic of the battery cells, the swelling value of the battery cells within the battery module, the swelling value of the entire battery module, etc.

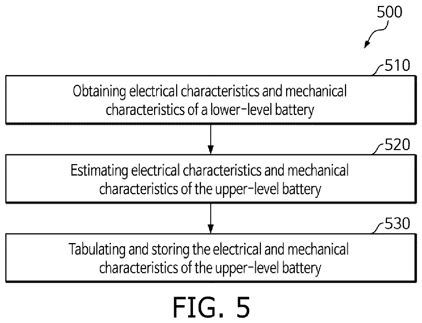

FIG. 5 is a flowchart for describing a method of tabulating characteristics of an upper-level battery in accordance with some embodiments of the present disclosure. Here, the characteristics of the upper-level battery may include mechanical characteristics and electrical characteristics. At least some steps of a method 500 may be performed by at least one processor. Referring to FIG. 5, the method 500 may begin with obtaining electrical characteristics and mechanical characteristics of a lower-level battery (at act 510). For example, data may be obtained by monitoring the lower-level battery. The monitored data may include at least one of position sensor data, pressure sensor data, state of charge (SOC) data, or output data. As another example, data may be obtained by performing charge/discharge cycle tests on the lower-level battery. The electrical and mechanical characteristics of the lower-level battery may be obtained by using the data obtained by performing monitoring and/or tests. Insufficient data/characteristics in this process may be supplemented using artificial neural network models.

Next, the electrical characteristics and mechanical characteristics of the upper-level battery may be estimated (at act 520). For example, the electrical and mechanical characteristics of the lower-level battery may be extended to the electrical and mechanical characteristics of the upper-level battery by using an extension algorithm and/or model. In some embodiments, the extension algorithm and/or model may include the correlation model described in FIG. 3. However, there are no limitations on this type of model, as other appropriate models may be used.

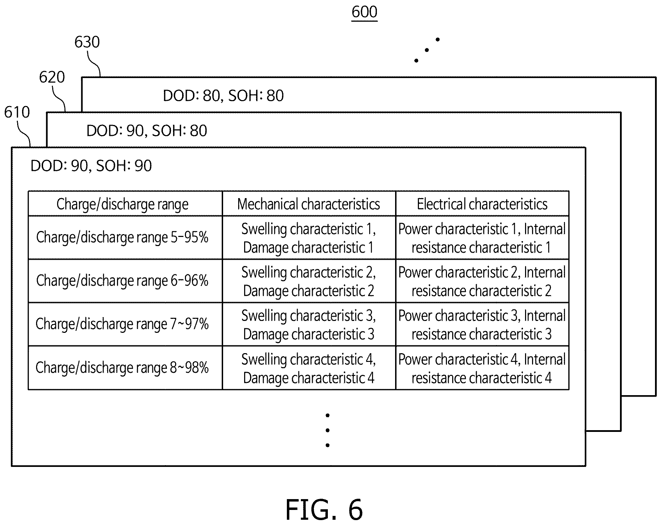

Next, the electrical and mechanical characteristics of the upper-level battery may be tabulated and stored (at act 530). For example, the mechanical and electrical characteristics of the upper-level battery according to the depth of discharge (DOD) and state of health (SOH) may be stored in lookup tables. The lookup tables will be described in detail with reference to FIG. 6.

FIG. 6 is a diagram for describing lookup tables in accordance with some embodiments of the present disclosure. Referring to FIG. 6, a plurality of lookup tables 600 may include first to third lookup tables 610, 620, and 630. In the following, the first lookup table 610 will be described, and the second and third lookup tables 620 and 630 will be described focusing on their differences from the first lookup table 610.

'DOD 90% tables' may refer to lookup tables with a DOD of 90%. For example, the 'DOD 90% tables' may include a lookup table with an SOH of 100%, a lookup table with an SOH of 90%, a lookup table with an SOH of 80%, etc., all with a DOD of 90%. Further, each lookup table included in the 'DOD 90% tables' may include mechanical characteristics and electrical characteristics for each of a plurality of charge/discharge ranges where the DOD is 90%, such as a charge/discharge range of 5 to 95%, a charge/discharge range of 6 to 96%, a charge/discharge range of 7 to 97%, etc.

The first lookup table 610 may include mechanical characteristics and electrical characteristics of an upper-level battery for each of a plurality of charge/discharge ranges at DOD 90% and SOH 90%. The mechanical characteristics may include a swelling characteristic and a damage characteristic. The electrical characteristics may include a power characteristic and an internal resistance characteristic. For example, if the charge/discharge range is 5 to 95% in the first lookup table 610, the mechanical characteristics of the upper-level battery may have a swelling characteristic 1 and a damage characteristic 1, and the electrical characteristics may have a power characteristic 1 and an internal resistance characteristic 1. The plurality of charge/discharge ranges included in the first lookup table 610 may have the same depth of discharge (DOD) of 90%, but the start points and end points of the charge/discharge ranges may be different. The first lookup table 610 is shown as including four charge/discharge ranges in FIG. 6, but is not limited thereto. For example, the first lookup table 610 may include mechanical and electrical characteristics associated with all charge/discharge ranges where the charge/discharge range is 90% (e.g., the start and end points vary by 90). The lookup tables may include mechanical characteristics and electrical characteristics for each charge/discharge range candidate.

The second lookup table 620 may include mechanical characteristics and electrical characteristics of the upper-level battery for each of a plurality of charge/discharge ranges at DOD 90% and SOH 80%. The third lookup table 630 may include mechanical characteristics and electrical characteristics of the upper-level battery for each of a plurality of charge/discharge ranges at DOD 80% and SOH 80%. FIG. 6 shows that the plurality of lookup tables 600 includes the first to third lookup tables 610, 620, and 630, which, however, should be understood as an example. For example, the plurality of lookup tables 600 may include lookup tables according to various DODs and SOHs.

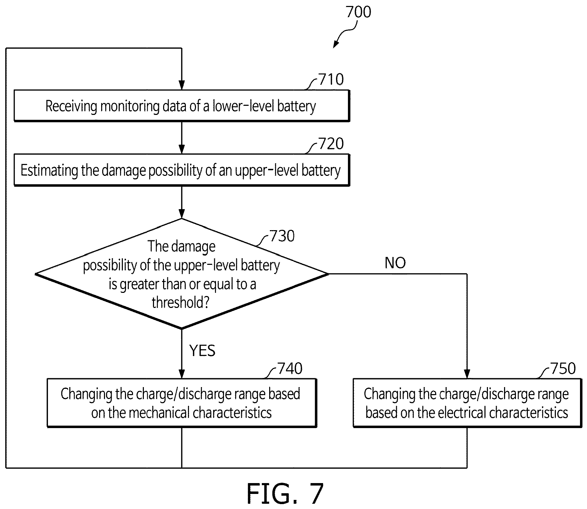

FIG. 7 is a flowchart for describing a battery management method 700 in accordance with some embodiments of the present disclosure. The method 700 may be performed by at least one processor. Referring to FIG. 7, the method 700 may begin with the processor receiving monitoring data of a lower-level battery (at act 710). For example, position sensor data, pressure sensor data, state of charge data, output data, etc., of the lower-level battery may be received via sensors (e.g., position sensors, pressure sensors, electrical signal sensors, etc.) attached to the lower-level battery. The (at least one) processor may process mechanical characteristics (e.g., a swelling characteristic and a damage characteristic) and electrical characteristics (e.g., a power characteristic and an internal resistance characteristic) data of the lower-level battery based on the monitoring data of the lower-level battery described above. As another example, the processor may receive the mechanical and electrical characteristic data of the lower-level battery processed based on the monitoring data of the lower-level battery described above. The processor may receive the mechanical and electrical characteristic data of the lower-level battery in real-time, periodically at predetermined intervals, or aperiodically.

Next, the processor may estimate the damage possibility of an upper-level battery (at act 720). In some embodiments, at least one of electrical characteristics and mechanical characteristics of the upper-level battery may be estimated based on the electrical and mechanical characteristics of the lower-level battery. The damage possibility of the upper-level battery may be estimated based on at least one of the estimated mechanical or electrical characteristics of the upper-level battery.

In some embodiments, the processor may determine swelling data of the lower-level battery based on at least one of position sensor data or pressure sensor data associated with the lower-level battery. Further, the processor may determine a damage characteristic of the lower-level battery based on at least one of swelling data, state of charge data, or power data of the lower-level battery. Thereafter, the processor may estimate a damage characteristic of the upper-level battery based on the damage characteristic of the lower-level battery.

In some embodiments, the damage possibility of the upper-level battery may be estimated using the method described in the table 400 of FIG. 4. However, there are no limitations on this estimation.

In some embodiments, the damage possibility of the upper-level battery may be estimated based on monitoring data of the lower-level battery and a predictive model. Here, the predictive model may be a model trained based on training data including first characteristic data (e.g., a mechanical and electrical characteristics of the lower-level batteries or an amount of appliance deformation of the lower-level batteries) associated with the lower-level battery and second characteristic data (e.g., a mechanical and electrical characteristics of the upper-level batteries or an amount of appliance deformation of the upper-level batteries) associated with the upper-level battery.

Next, the processor may determine whether the damage possibility of the upper-level battery is greater than or equal to a threshold (at act 730). For example, the processor may determine, based on the damage characteristic of the upper-level battery and a predetermined threshold, whether the damage possibility of the upper-level battery is greater than or equal to the threshold.

If it is determined (by the processor) that the damage possibility of the upper-level battery is greater than or equal to the predetermined threshold, the processor may change the charge/discharge range based on the mechanical characteristics (at act 740). For example, the charge/discharge range of the upper-level battery may be changed from a first charge/discharge range to a second charge/discharge range. Here, the upper-level battery may have a lower damage possibility in the second charge/discharge range than in the first charge/discharge range. For example, the safety of the upper-level battery can be improved by changing the charge/discharge range of the upper-level battery from the first charge/discharge range to the second charge/discharge range.

If it is determined (by the processor) that the damage possibility of the upper-level battery is less than the predetermined threshold, the processor may change the charge/discharge range based on the electrical characteristics (at act 750). For example, the processor may change the charge/discharge range of the upper-level battery from the first charge/discharge range to a third charge/discharge range. Here, the upper-level battery may have superior electrical characteristics in the third charge/discharge range than in the first charge/discharge range. Here, the superior electrical characteristics may be electrical characteristics associated with the driving pattern of a user. For example, the driving characteristics of a vehicle driven by a user can be improved by changing the charge/discharge range of the upper-level battery from the first charge/discharge range to the third charge/discharge range.

In some embodiments, the method 700 may be started again periodically or aperiodically after the step/act 740 of changing the charge/discharge range based on the mechanical characteristics. Further, the method 700 may be started again periodically or aperiodically after the step/act 750 of changing the charge/discharge range based on the electrical characteristics.

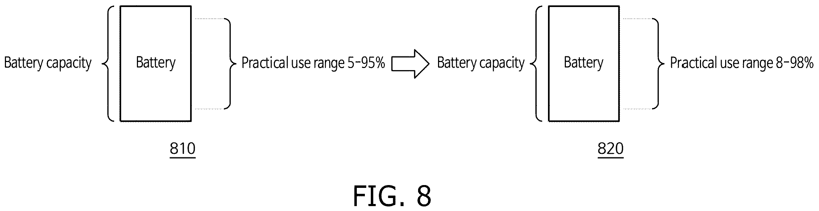

FIG. 8 is a diagram for describing a charge/discharge range and a practical use range of a battery in accordance with some embodiments of the present disclosure. The battery in FIG. 8 may refer to an upper-level battery. FIG. 8 shows an example of changing the charge/discharge range of the battery from a first charge/discharge range to a second charge/discharge range. In this case, the battery may change from a first state 810 to a second state 820.

The battery may have the first charge/discharge range in the first state 810, and the battery may have the second charge/discharge range in the second state 820. In the first state 810, the depth of discharge (DOD) of the battery may be 90%, and the first charge/discharge range may be 5 to 95%. In the second state 820, the depth of discharge (DOD) of the battery may be 90%, and the second charge/discharge range may be 8 to 98%. Here, the depths of discharge (DODs) of the first charge/discharge range and the second charge/discharge range may be the same at 90%. For example, the usage capacity of the battery according to the first charge/discharge range may be the same as the usage capacity of the battery according to the second charge/discharge range. The start points and end points of the first charge/discharge range and the second charge/discharge range may be different. Further, the mechanical characteristics and electrical characteristics of the first charge/discharge range and the second charge/discharge range may be different from each other.

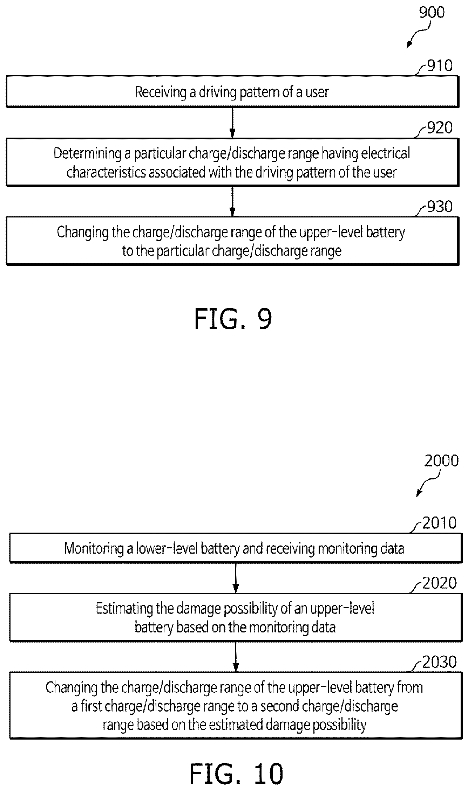

FIG. 9 is a diagram for describing a method of changing a charge/discharge range based on electrical characteristics in accordance with some embodiments of the present disclosure. A method 900 may be performed by a processor. Referring to FIG. 9, the method 900 may begin with the processor receiving a driving pattern of a user (at act 910). For example, the processor may receive a driving pattern of a user associated with the driving distance, driving speed, acceleration performance, etc., of a vehicle driven by the user.

The processor may determine a particular charge/discharge range having electrical characteristics associated with the driving pattern of the user (at act 920). For example, a charge/discharge range having electrical characteristics associated with the driving pattern of the user may be determined out of a plurality of predetermined charge/discharge range candidates. The electrical characteristics associated with the driving pattern of the user may include a power characteristic, an internal resistance characteristic, etc. For example, if the driving pattern of the user is associated more with long driving distances than high-speed driving, the processor may determine a charge/discharge range having a superior internal resistance characteristic. In another example, if the driving pattern of the user is associated with high acceleration performance, the processor may determine a charge/discharge range having a superior power characteristic. Next, the processor may change the charge/discharge range of the upper-level battery to the particular charge/discharge range determined (at act 930).

FIG. 10 is a diagram for describing a battery management method in accordance with some embodiments of the present disclosure. At least some steps of a method 2000 may be performed by at least one processor. For example, the method 2000 may be performed by at least one processor of a battery management system (BMS).

Referring to FIG. 10, the method 2000 may begin with the processor monitoring a lower-level battery and receiving monitoring data (at act 2010). Here, the monitoring data may include at least one of position sensor data, pressure sensor data, state of charge data, or power data associated with the lower-level battery.

Next, the processor may estimate the damage possibility of an upper-level battery including the lower-level battery based on the received monitoring data (at act 2020). In some embodiments, estimating the damage possibility by the processor may include determining mechanical and electrical characteristics of the lower-level battery based on the monitoring data, estimating at least one of mechanical characteristics or electrical characteristics of the upper-level battery based on the mechanical and electrical characteristics of the lower-level battery, and estimating the damage possibility of the upper-level battery based on at least one of the estimated mechanical or electrical characteristics of the upper-level battery.

Here, determining the mechanical and electrical characteristics of the lower-level battery may include determining swelling data of the lower-level battery based on at least one of position sensor data or pressure sensor data associated with the lower-level battery, and determining a damage characteristic of the lower-level battery based on at least one of the swelling data, state of charge data, or power data of the lower-level battery.

In other embodiments, the mechanical and electrical characteristics of the upper-level battery may be estimated using a predefined correlation model between the lower-level battery and the upper-level battery.

In some embodiments, estimating the damage possibility by the processor may include determining swelling data of the lower-level battery based on at least one of position sensor data or pressure sensor data associated with the lower-level battery, determining a damage characteristic of the lower-level battery based on at least one of the swelling data, state of charge data, or power data of the lower-level battery, and estimating a damage characteristic of the upper-level battery based on the damage characteristic of the lower-level battery.

Next, the processor may change the charge/discharge range of the upper-level battery from a first charge/discharge range to a second charge/discharge range based on the estimated damage possibility (at act 2030). Here, the depths of discharge of the first charge/discharge range and the second charge/discharge range may be the same, and the start points and end points of the first charge/discharge range and the second charge/discharge range may be different. In other examples, the usage capacity of the upper-level battery according to the first charge/discharge range may be the same as the usage capacity of the upper-level battery according to the second charge/discharge range.

In some embodiments, changing the charge/discharge range of the upper-level battery from the first charge/discharge range to the second charge/discharge range by the processor may include selecting the second charge/discharge range, which is one of a plurality of predetermined charge/discharge range candidates, based on at least one of the depth of discharge (DOD) of the first charge/discharge range, a state of health (SOH) of the upper-level battery, target mechanical characteristics, or target electrical characteristics. Here, the first charge/discharge range and the plurality of predetermined charge/discharge range candidates may all have the same depth of discharge. Here, the mechanical characteristics may include a swelling characteristic and a damage characteristic. Here, the electrical characteristics may include an internal resistance characteristic and a power characteristic.

In some embodiments, changing the charge/discharge range of the upper-level battery from the first charge/discharge range to the second charge/discharge range by the processor may include changing the charge/discharge range of the upper-level battery from the first charge/discharge range to the second charge/discharge range in response to determining that the estimated damage possibility is greater than or equal to a predetermined threshold, wherein the upper-level battery may have a lower damage possibility in the second charge/discharge range than in the first charge/discharge range.

In some embodiments, changing the charge/discharge range of the upper-level battery from the first charge/discharge range to the second charge/discharge range by the processor may include changing the charge/discharge range of the upper-level battery from the first charge/discharge range to the second charge/discharge range in response to determining that the estimated damage possibility is less than the predetermined threshold, wherein the upper-level battery may have superior electrical characteristics in the second charge/discharge range than in the first charge/discharge range.

In some embodiments, changing the charge/discharge range of the upper-level battery from the first charge/discharge range to the second charge/discharge range by the processor may include determining that the estimated damage possibility is less than the predetermined threshold, receiving a driving pattern of a user, and selecting the second charge/discharge range having electrical characteristics associated with the driving pattern of the user out of a plurality of predetermined charge/discharge range candidates.

The flowchart shown in FIG. 10 and the foregoing description are merely examples and may be implemented differently in some embodiments. For example, one or more steps may be omitted, the order of each step may be changed, one or more steps may be performed in an overlapping manner, or one or more steps may be repeated multiple times.

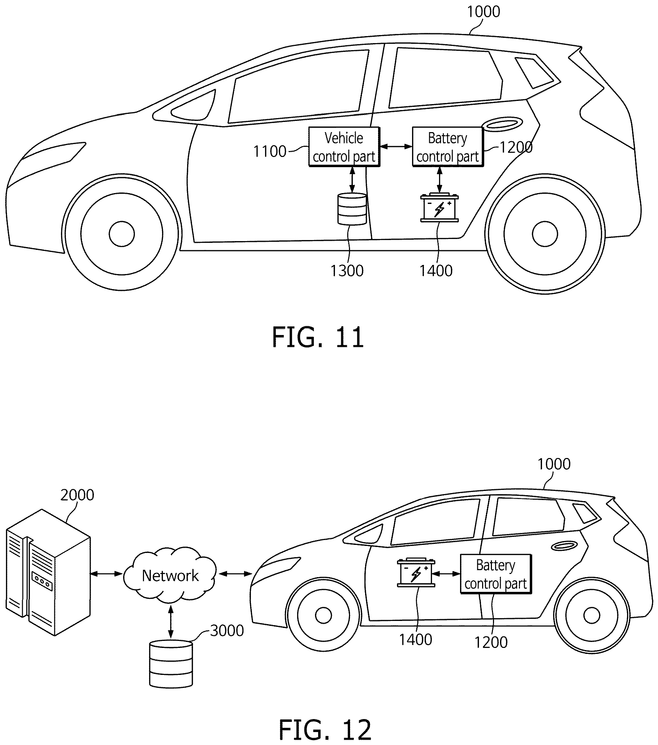

FIG. 11 is a diagram for describing a vehicle 1000 in accordance with some embodiments of the present disclosure. Referring to FIG. 11, the vehicle 1000 may include a vehicle control part 1100, a battery control part 1200, a database 1300, and a battery 1400. The vehicle control part 1100 and the battery control part 1200 may each include at least one processor. For example, the battery control part 1200 may include a battery management system (BMS). The battery 1400 may include an upper-level battery that includes a lower-level battery, such as described herein.

The battery control part 1200 may obtain monitoring data by monitoring some of a plurality of battery cells included in the battery 1400. For example, the monitoring data may include mechanical and electrical characteristic data of the battery cells. The battery control part 1200 may transfer the monitoring data to the vehicle control part 1100.

The vehicle control part 1100 may include an operating system and at least one program code (e.g., program code for estimating the damage possibility of the upper-level battery). The database 1300 may include a plurality of lookup tables generated from the relationship between the depth of discharge (DOD) and state of health (SOH) of the upper-level battery and the characteristics (e.g., mechanical characteristics and electrical characteristics) of the upper-level battery. Further, the database 1300 may include a predefined correlation model between the lower-level battery and the upper-level battery, such as described herein.

The vehicle control part 1100 may estimate the damage possibility of the upper-level battery based on the monitoring data of the lower-level battery and the correlation model. The vehicle control part 1100 may determine whether the damage possibility is greater than or equal to a predetermined threshold and select a charge/discharge range based on the determination result. For example, the vehicle control part 1100 may change the charge/discharge range of the upper-level battery based on the determination result and the lookup tables stored in the memory. Thereafter, the battery control part 1200 may control the charge/discharge of the battery 1400 based on the changed charge/discharge range.

FIG. 12 is a diagram for describing an example in which a vehicle 1000 and a vehicle control part 2000 communicate with each other in accordance with some embodiments of the present disclosure. Referring to FIG. 12, the vehicle 1000 may include a battery control part 1200, a battery 1400, and a communication part (not shown). The vehicle 1000 may transmit and receive data to and from a vehicle control part 2000 and/or a database 3000 over a network by using the communication part. The vehicle control part 2000 and the battery control part 1200 may each include at least one processor. For example, the battery control part 1200 may include a battery management system (BMS), and the vehicle control part 2000 may be an information processing system (e.g., a server) outside the vehicle.

The vehicle 1000 may transfer monitoring data to the vehicle control part 2000 over the network. The vehicle control part 2000 may include an operating system and at least one program code (e.g., program code for estimating the damage possibility of an upper-level battery). The database 3000 may include a plurality of lookup tables generated from the relationship between the depth of discharge (DOD) and state of health (SOH) of the upper-level battery and characteristics (e.g., mechanical characteristics and electrical characteristics) of the upper-level battery. Further, the database 3000 may include a predefined correlation model between a lower-level battery and the upper-level battery, such as described herein.

The vehicle control part 2000 may estimate the damage possibility of the upper-level battery based on the monitoring data of the lower-level battery received from the vehicle 1000 and the correlation model stored in the database 3000. The vehicle control part 2000 may determine whether the damage possibility is greater than or equal to a predetermined threshold and select a charge/discharge range based on the determination result. For example, the vehicle control part 2000 may change the charge/discharge range of the upper-level battery based on the determination result and the lookup tables stored in the memory. Thereafter, the vehicle control part 2000 may transfer the changed charge/discharge range to the vehicle 1000. Thereafter, the battery control part 1200 may control the charge/discharge of the battery 1400 based on the changed charge/discharge range.

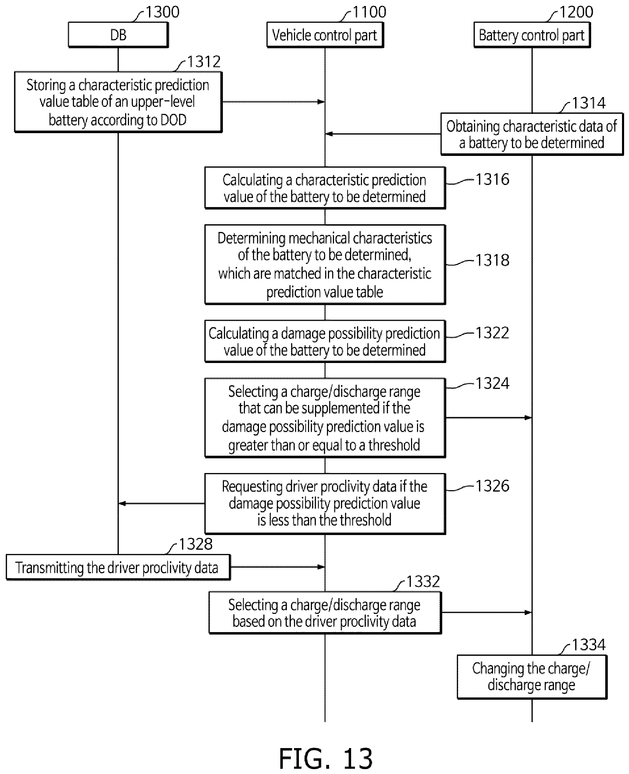

FIG. 13 is a diagram showing an example of controlling a charge/discharge range based on driver proclivity data and a possibility of battery damage in accordance with some embodiments of the present disclosure. In some embodiments, a database 1300 may store a characteristic prediction value table (e.g., a plurality of lookup tables, etc.) generated from the relationship between the depth of discharge (DOD) and state of health (SOH) of an upper-level battery and characteristics (e.g., mechanical characteristics and electrical characteristics) of the upper-level battery (at act 1312). Further, the database 1300 may store a predefined correlation model between a lower-level battery and the upper-level battery.

In some embodiments, a battery control part 1200 may obtain characteristic data of a battery to be determined (analyzed) by monitoring some of a plurality of battery cells included in the battery (at act 1314). For example, the battery control part 1200 may obtain position sensor data, pressure sensor data, state of charge data, power data, etc., of the lower-level battery via sensors (e.g., position sensors, pressure sensors, electrical signal sensors, etc.) attached to the lower-level battery. The battery control part 1200 may transfer the characteristic data of the battery to be determined (analyzed) to a vehicle control part 1100.

In some embodiments, the vehicle control part 1100 may calculate a characteristic prediction value of the battery to be determined (analyzed) based on the received characteristic data of the battery to be analyzed (at act 1316). Thereafter, the vehicle control part 1100 may determine mechanical characteristics of the battery to be determined (analyzed), which are matched in the characteristic prediction value table, based on the characteristic prediction value of the battery to be determined/analyzed (at act 1318). The vehicle control part 1100 may calculate a damage possibility prediction value of the battery to be determined/analyzed based on the mechanical characteristics of the battery to be determined/analyzed (at act 1322).

If the damage possibility prediction value calculated is greater than or equal to a predetermined threshold, the vehicle control part 1100 may select a charge/discharge range that can be supplemented (at act 1324), and transmit the selected charge/discharge range to the battery control part 1200. For example, the vehicle control part 1100 may change the charge/discharge range of the upper-level battery from a first charge/discharge range to a second charge/discharge range. Here, the upper-level battery may have a lower damage possibility in the second charge/discharge range than in the first charge/discharge range. For example, the safety of the upper-level battery can be improved by changing the charge/discharge range of the upper-level battery from the first charge/discharge range to the second charge/discharge range. In some examples, the depths of discharge of the first charge/discharge range and the second charge/discharge range may be the same. Further, the start points and end points of the first charge/discharge range and the second charge/discharge range may be different. Moreover, the usage capacity of the upper-level battery according to the first charge/discharge range may be the same as the usage capacity of the upper-level battery according to the second charge/discharge range.

If the damage possibility prediction value calculated is less than the predetermined threshold, the vehicle control part 1100 may request driver proclivity data from the database 1300 (at act 1326). In this case, the database 1300 may transmit the driver proclivity data to the vehicle control part 1100 (at act 1328). The vehicle control part 1100 may select a charge/discharge range based on the received driver proclivity data (e.g., the proclivity data of a driver who uses the battery to be determined/analyzed) (at act 1332), and transmit the selected charge/discharge range to the battery control part 1200. For example, the driver proclivity data may include a driving pattern of a user associated with the driving distance, driving speed, acceleration performance, etc., of a vehicle driven by the user. In one example, the vehicle control part 1100 may change the charge/discharge range of the upper-level battery from the first charge/discharge range to a third charge/discharge range. Here, the upper-level battery may have superior electrical characteristics in the third charge/discharge range than in the first charge/discharge range. Here, the superior electrical characteristics may be electrical characteristics associated with the driving proclivity data of the user. For example, the driving characteristics of the vehicle driven by the user can be improved by changing the charge/discharge range of the upper-level battery from the first charge/discharge range to the third charge/discharge range. In some examples, the depths of discharge of the first charge/discharge range and the third charge/discharge range may be the same. Further, the start points and end points of the first charge/discharge range and the third charge/discharge range may be different. Moreover, the usage capacity of the upper-level battery according to the first charge/discharge range and the usage capacity of the upper-level battery according to the third charge/discharge range may be the same.

In some embodiments, the battery control part 1200 may change the charge/discharge range of the battery to be determined/analyzed based on the charge/discharge range (e.g., the second charge/discharge range, the third charge/discharge range, etc.) received from the vehicle control part 1110 (at act 1334). For example, the battery control part 1200 may change the charge/discharge range of the upper-level battery and control the charge/discharge of the upper-level battery according to the changed charge/discharge range.

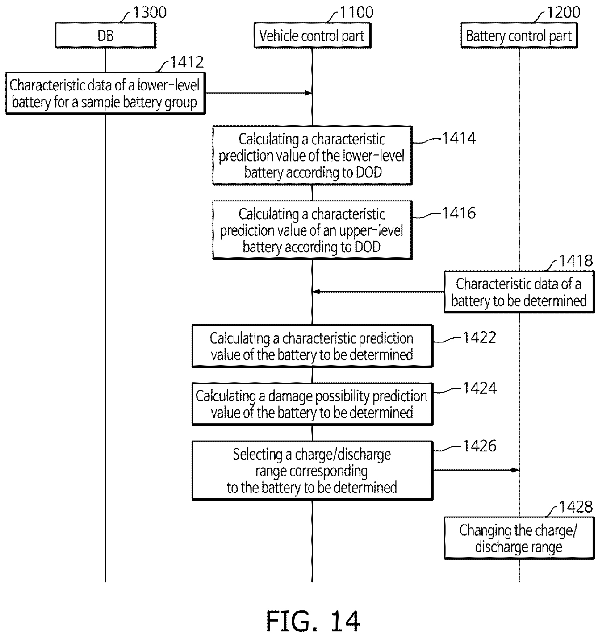

FIG. 14 is a diagram showing an example of controlling a charge/discharge range based on a possibility of battery damage in accordance with some embodiments of the present disclosure. In some embodiments, a database 1300 may store characteristic data of a lower-level battery for a sample battery group (at act 1412).

In some embodiments, a vehicle control part 1100 may calculate a characteristic prediction value of the lower-level battery according to the depth of discharge (DOD) (at act 1414). Further, the vehicle control part 1100 may calculate a characteristic prediction value of an upper-level battery according to the depth of discharge (DOD) (at act 1416). For example, the vehicle control part may generate a correlation model between the lower-level battery and the upper-level battery, based on the characteristic prediction value of the lower-level battery according to the depth of discharge (DOD) and the characteristic prediction value of the upper-level battery according to the depth of discharge (DOD) that have been calculated.

In some embodiments, a battery control part 1200 may obtain characteristic data of a battery to be determined/analyzed by monitoring some of a plurality of battery cells included in the battery (at act 1418). For example, the battery control part 1200 may obtain position sensor data, pressure sensor data, state of charge data, power data, etc., of the lower-level battery via sensors (e.g., position sensors, pressure sensors, electrical signal sensors, etc.) attached to the lower-level battery. The battery control part 1200 may transfer the characteristic data of the battery to be determined/analyzed to the vehicle control part 1100.

In some embodiments, the vehicle control part 1100 may calculate a characteristic prediction value of the battery to be determined/analyzed based on the received characteristic data of the battery to be determined/analyzed (at act 1422). Thereafter, the vehicle control part 1100 may calculate a damage possibility prediction value of the battery to be determined/analyzed based on the characteristic prediction value of the battery to be determined/analyzed (at act 1424). For example, the vehicle control part 1100 may calculate the damage possibility prediction value of the battery to be determined/analyzed based on the characteristic prediction value of the battery to be determined/analyzed and the correlation model between the lower-level battery and the upper-level battery.

In some embodiments, the vehicle control part 1100 may select a charge/discharge range corresponding to the battery to be determined/analyzed based on the damage possibility prediction value calculated (at act 1426) and transmit the selected charge/discharge range to the battery control part 1200. The battery control part 1200 may change the charge/discharge range of the battery to be determined/analyzed based on the charge/discharge range received from the vehicle control part 1110 (at act 1428). For example, the battery control part 1200 may change the charge/discharge range of the upper-level battery and control the charge/discharge of the upper-level battery according to the changed charge/discharge range.

Although the present disclosure has been described above with respect to embodiments thereof, the present disclosure is not limited thereto. Various modifications and variations can be made thereto by those skilled in the art within the scope of the present disclosure and the equivalent scope of the appended claims.

## Claims

1. A battery management method (300, 500, 700, 900, 2000) comprising:
monitoring (2010) a lower-level battery (112) and receiving monitoring data;
estimating (2020) a damage possibility of an upper-level battery (110) comprising the lower-level battery (112) based on the received monitoring data; and
changing (2030) a charge/discharge range of the upper-level battery (110) from a first charge/discharge range to a second charge/discharge range based on the estimated damage possibility.

2. The battery management method (300, 500, 700, 900, 2000) as claimed in claim 1, wherein the changing (2030) to the second charge/discharge range comprises:
selecting the second charge/discharge range, which is one of a plurality of predetermined charge/discharge range candidates, based on at least one of a depth of discharge, DOD, of the first charge/discharge range, a state of health, SOH, of the upper-level battery (110) 110, target mechanical characteristics, or target electrical characteristics.

3. The battery management method (300, 500, 700, 900, 2000) as claimed in claim 2, wherein the first charge/discharge range and the plurality of predetermined charge/discharge range candidates all have the same depth of discharge.

4. The battery management method (300, 500, 700, 900, 2000) as claimed in claims 2 or 3, wherein the target mechanical characteristics comprise a swelling characteristic and a damage characteristic.

5. The battery management method (300, 500, 700, 900, 2000) as claimed in claims 2 to 4, wherein the target electrical characteristics comprise an internal resistance characteristic and a power characteristic.

6. The battery management method (300, 500, 700, 900, 2000) as claimed in claims 1 to 5, wherein the changing (2030) to the second charge/discharge range comprises:
changing (740) the charge/discharge range of the upper-level battery (110) from the first charge/discharge range to the second charge/discharge range in response to determining that the estimated damage possibility is greater than or equal to a predetermined threshold, and
wherein the upper-level battery (110) has a lower damage possibility in the second charge/discharge range than in the first charge/discharge range.

7. The battery management method (300, 500, 700, 900, 2000) as claimed in claims 1 to 5, wherein the changing (2030) to the second charge/discharge range comprises:
changing (750) the charge/discharge range of the upper-level battery (110) from the first charge/discharge range to the second charge/discharge range in response to determining that the estimated damage possibility is less than a predetermined threshold, and
wherein the upper-level battery (110) is predicted to have superior electrical characteristics in the second charge/discharge range than in the first charge/discharge range.

8. The battery management method (300, 500, 700, 900, 2000) as claimed in claims 1 to 5, wherein the changing (2030) to the second charge/discharge range comprises:
determining that the estimated damage possibility is less than a predetermined threshold;
receiving a driving pattern of a user; and
selecting the second charge/discharge range having electrical characteristics associated with the driving pattern of the user out of a plurality of predetermined charge/discharge range candidates.

9. The battery management method (300, 500, 700, 900, 2000) as claimed in claims 1 to 5, wherein depths of discharge of the first charge/discharge range and the second charge/discharge range are the same, and
start points and end points of the first charge/discharge range and the second charge/discharge range are different.

10. The battery management method (300, 500, 700, 900, 2000) as claimed in claims 1 to 5, wherein a usage capacity of the upper-level battery (110) according to the first charge/discharge range and a usage capacity of the upper-level battery (110) according to the second charge/discharge range are the same.

11. The battery management method (300, 500, 700, 900, 2000) as claimed in claims 1 to 11, wherein the estimating the damage possibility of the upper-level battery (110) comprises:
determining mechanical characteristics and electrical characteristics of the lower-level battery (112) based on the monitoring data;
estimating at least one of mechanical characteristics or electrical characteristics of the upper-level battery (110) based on the mechanical characteristics and electrical characteristics of the lower-level battery (112); and
estimating the damage possibility of the upper-level battery (110) based on at least one of the estimated mechanical characteristics or electrical characteristics of the upper-level battery (110).

12. The battery management method (300, 500, 700, 900, 2000) as claimed in claims 1 to 11, wherein the monitoring data comprises at least one of position sensor data, pressure sensor data, state of charge (SOC) data, or power data associated with the lower-level battery (112) 112, and
wherein the estimating of the damage possibility of the upper-level battery (110) comprises:
determining swelling data of the lower-level battery (112) based on at least one of the position sensor data or the pressure sensor data associated with the lower-level battery (112);
determining a damage characteristic of the lower-level battery (112) based on at least one of the swelling data, the state of charge data, or the power data of the lower-level battery (112); and
estimating a damage characteristic of the upper-level battery (110) based on the damage characteristic of the lower-level battery (112).

13. The battery management method (300, 500, 700, 900, 2000) as claimed in claims 2 to 11, wherein the plurality of predetermined charge/discharge range candidates are stored in lookup tables (600), and
wherein the lookup tables (600) comprise mechanical characteristics and electrical characteristics (1) for each charge/discharge range candidate of the plurality of predetermined charge/discharge range candidates.

14. The battery management method (300, 500, 700, 900, 2000) as claimed in claims 1 to 13, wherein the upper-level battery (110) comprises a plurality of lower-level batteries including the lower-level battery (112), and
the monitoring data is obtained from some of the plurality of lower-level batteries.

15. A battery management system (100) comprising:
a memory (140); and
at least one processor (130) connected to the memory (140) and configured to execute at least one computer-readable program included in the memory (140),
wherein the at least one computer-readable program comprises instructions for:
monitoring (2010) a lower-level battery (112) and receiving monitoring data,
estimating (2020) a damage possibility of an upper-level battery (110) comprising the lower-level battery (112) based on the received monitoring data, and
changing (2030) a charge/discharge range of the upper-level battery (110) from a first charge/discharge range to a second charge/discharge range based on the estimated damage possibility.
